# EUROPEAN PATENT SPECIFICATION

(11) **EP 4 746 429 B1**
(45) Date of publication and mention of the grant of the patent: **16.09.2026**
(21) Application number: 24212991.4
(22) Date of filing: 14.11.2024
(51) Int. Cl.: H04N 23/54, H05K 1/14

(54) **A CAMERA DEVICE**
KAMERAVORRICHTUNG
DISPOSITIF DE CAMÉRA

(43) Date of publication of application: 20.05.2026
(73) Proprietor: Axis AB, 223 69 Lund (SE)
(72) Inventor: Lind, Fabian, 223 69 Lund (SE); Danelius, Jöns, 223 69 Lund (SE); Zejnullahu, Arbias, 223 69 Lund (SE); Karida, Déspina, 223 69 Lund (SE); Wedmark, Jessica, 223 69 Lund (SE)
(74) Representative: AWA Sweden AB

(56) References cited:
- US-A1- 2004 047 050
- US-A1- 2007 171 639
- US-A1- 2019 090 356
- US-A1- 2019 132 954

## Description

### Field of the invention

The present invention relates to a camera device.

### Background art

Camera devices are commonly used for surveillance and can be used in various locations. They can be placed both indoors and outdoors, for example in ATMs, banks, stores and hotels. They may also be placed on board different types of vehicles, such as in public transportation, police cars, ambulances, and race cars. These types of installation sites are often tight in space and require that the camera device is compact and discreet.

However, a compact camera device will affect the configuration of the different components in order to fit in the small camera housing. This may limit which components can be used and may in turn put restraints on the resolution of the camera device. Thus, compact camera devices may compromise with the image quality and resolution.

Hence there is a need for an improved camera device.

Relevant prior art may be found in US 2007/171639 A1, US 2019/090356 A1, US 2019/132954 A1 and US 2004/047050 A1.

US 2007/171639 A1 discloses a light emitting apparatus including a plurality of printed circuit boards connected to each other by means of connectors disposed between the printed circuit boards.

US 2019/090356 A1 discloses a printed circuit board assembly comprising a plurality of printed circuit boards which may be stacked on top of each other and connected by means of snap on fasteners.

US 2019/132954 A1 discloses a device for fixing a camera module comprising a plurality of boards of a printed circuit board.

US 2004/047050 A1 discloses a device including an electrochromic element and a base substrate disposed in a spaced relation to the electrochromic element.

### Summary of the invention

To achieve at least one of the above objects and also other objects that will be evident from the following description, a device having the features defined in claim 1 is provided according to the present invention. Preferred embodiments will be evident from the dependent claims.

More specifically, there is provided according to a first aspect of the present invention a camera device comprising a first printed circuit board (PCB) segment provided with a first grounding contact surface, a second PCB segment provided with an opening defined by a portion of the second PCB segment forming a second grounding contact surface, a chassis made of an electrically conductive material, a clip made of an electrically conductive material and snap fitted to the chassis, wherein the chassis is configured to support an image sensor and the first and second PCB segment, wherein the first PCB segment is arranged between the chassis and the second PCB segment, wherein the clip comprises a first contact portion abutting the first
grounding contact portion of the first PCB segment; and a second contact portion extending through the opening of the second PCB segment and engaging the second grounding contact surface thereof.

The clip serves a purpose of holding the first and the second PCB segment in place, both during assembly and during use.

Since the clip is electrically conductive, the clip also serves a grounding purpose of the first and the second PCB segment. By engaging a first and a second grounding contact surface of the first and the second PCB segment while being snap fitted to the electrically conductive chassis, any power spikes can be led through the clip instead of the connected PCB segments. Thereby, electrical components on the first and the second PCB segment are protected from damage caused by such a power spike.

The clip is made of an electrically conductive material. For example the clip may be punched out from a sheet of steel, or any other suitable material, and then be bent to its shape. However, the clip may comprise a plurality of materials, some of which may not be electrically conductive.

An electrically conductive material is to be understood as a material with high electrically conductive properties compared with other materials. For example, materials such as copper or aluminium are considered to be materials with high electrically conductive properties.

The configuration of the camera device provides that the PCB segments may be stacked on top of each other and thereby be more space efficient. The PCB segments may be connected by a flex cable or by a flexible printed circuit (FPC) film being a layer in each PCB segment. Alternatively, board to board connectors may be used. In other words, the first and the second PCB segment may be two individual PCBs, connected to each other by a flex cable. Alternatively, the first and the second PCB segment may be portions of a single PCB. The single PCB may be divided into the first and the second PCB segment by removing hard layers of the single PCB between the first and the second PCB segment, such that the first and the second PCB segment are flexibly connected by the FPC film. Alternatively, the single PCB is produced such that the hard layers between the PCB segments are not present.

The clip comprises at least two legs extending in parallel with a longitudinal axis of the camera device. The at least two legs straddle the first PCB segment, and each of the at least two legs is provided with a distal end configured for snap fit attachment to the chassis.

For example, the at least two legs may extend along the longitudinal axis on opposing sides of the first PCB segment.

The clip may comprise a bridging portion extending perpendicular to the longitudinal axis and connecting the at least two legs. The bridging portion may comprise the first contact portion.

That is, the clip may hold the first PCB segment in place by a clamping force between the bridging portion of the clip and the chassis. Since the bridging portion exerts a clamping force on the clip, it is ensured that the first contact portion of the clip always is in electrical contact with the first grounding contact surface of the first PCB segment. Thereby it is ensured that the first PCB segment always has a grounding connection when the camera device is assembled.

The clip may comprise a holder portion extending in parallel with a longitudinal axis of the camera device. The holder portion may have a distal end portion configured to be inserted into the opening of the second PCB segment for establishing a spring biased engagement between the holder portion and the second PCB segment. The distal end portion may comprise the second contact portion.

The spring biased engagement between the holder portion and the second PCB segment holds the second PCB segment in place by hindering displacement in a direction transverse to the longitudinal axis. However, the spring biased engagement still allows some movement of the second PCB in a direction along the longitudinal axis. Thereby the camera device may be produced with generous tolerances which facilitates the production and lowers the production cost of the camera device.

The spring biased engagement also ensures that the second PCB segment always has a grounding connection when the camera device is assembled.

The holder portion may extend from the bridging portion.

For example, the holder portion may extend in a direction parallel to the longitudinal axis of the camera device, or in a direction transverse to the longitudinal axis of the camera device.

The holder portion may extend with an offset to the longitudinal axis.

In other words, the holder portion may extend from the bridging portion such that the extension of the holder portion is separate from the longitudinal axis.

The distal end portion may be substantially U-shaped.

That is, the distal end portion of the holder portion of the clip may be bent such that a spring-like force can be exerted between two points of the distal end portion that are in contact with the second PCB segment.

The distal end portion may comprise a retaining edge being configured such that the holder portion is restricted from being inserted into the opening of the second PCB segment past the retaining edge.

That is, the retaining edge ensures that the second PCB segment cannot be pushed past the holder portion such that the spring biased engagement between the second PCB segment and the holder portion is lost.

The retaining edge may be formed by the distal end portion being bent such that an edge is created. However, a plurality of variations of the retaining edge is possible. For example, the retaining edge may be a protrusion extending from the distal end portion. Such a protrusion may be unitarily formed with the clip. Alternatively, such a protrusion may be a separate part that is fixedly connected to the distal end portion by any suitable fastening means.

The clip may be configured for sliding engagement with the chassis when snap fitted thereto.

That is, the clip is releasably attached to the chassis such that movement of the clip along the longitudinal axis of the camera device is prevented. However, when the camera device is assembled, the clip may slide along the chassis until the clip reaches an end position and snap-fits into the chassis.

The camera device may further comprise a third PCB segment provided with the image sensor. The third PCB segment may be arranged between the chassis and the first PCB segment.

The third PCB segment may be coupled to the first PCB segment by a FPC film or a flex cable. Several different combinations of the coupling between the PCB segments are possible. For example, the first, the second and the third PCB segment may be three individual PCBs, which are coupled by flex cables. Alternatively, the first, the second and the third PCB segment may be portions of a single PCB divided into the three PCB segments. Hard layers of the single PCB between the three PCB segments may not be present such that the three PCB segments are flexibly connected by the FPC film. Alternatively, the first and the second PCB segment may be coupled by the FPC film while the third and the first PCB segment are coupled by a flex cable, or vice versa.

When the camera device is assembled, the third PCB segment provided with the image senor may initially float when placed on the chassis. This enables active alignment of the image sensor. Thereby camera sensors that require active alignment may be used in the camera device. Such camera sensors often have higher resolution than camera sensors that only require passive alignment. After the active alignment of the image sensor, the third PCB segment is fastened to the chassis.

Further, the third PCB may be in grounding connection with the chassis.

The camera device may further comprise a heat sink member arranged between the third PCB segment and the first PCB segment.

The heat sink may dissipate heat from the image sensor which otherwise may affect the image quality.

The camera device may further comprise a housing enclosing the first and second PCB segment.

The housing may fully surround the first and second PCB segment. Alternatively, the housing may be interrupted such that the housing partially surrounds the first and the second PCB segment. The chassis and the housing are individual components and formed as separate units which are not electrically coupled to each other.

The camera device may further comprise a lens unit.

According to a second aspect of the present invention, a camera system is provided comprising; a processing unit, and at least one camera device in accordance with the first aspect of the present invention, connected to the processing unit.

That is, the camera system may comprise a plurality of camera devices in accordance with the first aspect of the present invention, each camera being connected to the processing unit.

According to a third aspect of the present invention, a method for assembling a camera device is provided, the camera device comprising: a first PCB segment provided with a first grounding contact surface, a second PCB segment provided with an opening defined by a portion of the second PCB segment forming a second grounding contact surface, a third PCB segment provided with an image sensor, a heat sink member, a chassis made of an electrically conductive material, a clip made of an electrically conductive material; comprising a first contact portion and a second contact portion; and configured to be snap fitted to the chassis, the method comprising: attaching the third PCB segment to the chassis, arranging the heat sink member on the third PCB segment, arranging the first PCB segment on the heat sink member, snap fitting the clip to the chassis such that the clip encloses the first PCB segment and the first contact portion of the clip abuts the first grounding contact surface of the first PCB segment, arranging the second PCB segment on the clip such that the second contact portion of the clip extends through the opening of the second PCB segment and engages the second grounding contact surface thereof, whereby the clip restricts movement of the first and second PCB segment in a direction transverse to a longitudinal axis of the camera device.

Any benefit or technical effect which has been discussed in relation to the first aspect of the present invention, or any variant thereof, may be applicable to the second and third aspect of the present invention or any variant thereof, and will not be repeated to avoid undue repetition.

Generally, all terms used in the claims are to be interpreted according to their ordinary meaning in the technical field, unless explicitly defined otherwise herein. All references to "a/an/the [element, device, component, means, step, etc]" are to be interpreted openly as referring to at least one instance of said element, device, component, means, step, etc., unless explicitly stated otherwise. The steps of any method disclosed herein do not have to be performed in the exact order disclosed, unless explicitly stated.

### Brief description of the drawings

The above, as well as additional objects, features and advantages of the present invention, will be better understood through the following illustrative and non-limiting detailed description of preferred embodiments of the present invention, with reference to the appended drawings, where the same reference numerals will be used for similar elements, wherein:
Fig. 1 is a perspective view of the camera device;
Fig. 2 is a perspective view of the PCB segments;
Fig. 3a is a perspective view of the clip;
Fig. 3b is a front view of the clip;
Fig. 3c is a side view of the clip; and
Fig. 4 is an exploded view of the camera device;

### Description of embodiments

The present invention will now be described more fully hereinafter with reference to the accompanying drawings, in which currently preferred embodiments of the invention are shown. This invention may, however, be embodied in many different forms and should not be construed as limited to the embodiments set forth herein; rather, these embodiments are provided for thoroughness and completeness, and to fully convey the scope of the invention to the skilled person.

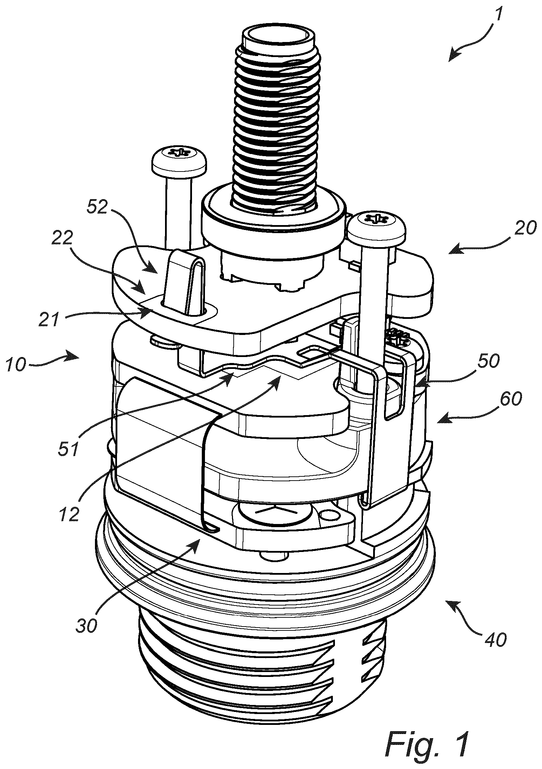

Fig. 1 is a perspective view of the camera device 1 according to the first aspect of the invention. The camera device 1 comprises a first PCB segment 10. The first PCB segment 10 is provided with a first grounding contact surface 12. The camera device 1 further comprises a second PCB segment 20. The second PCB segment 20 is provided with an opening 21. The opening 21 is defined by a portion of the second PCB segment 20 forming a second grounding contact surface 22.

The camera device 1 further comprises a chassis 40 made of an electrically conductive material. The camera device 1 also comprises a clip 50 made of an electrically conductive material. Here it is to be understood that the chassis 40 and the clip 50 may comprise other materials as well, that may or may not be electrically conductive. The clip 50 is snap fitted to the chassis 40.

The chassis 40 is configured to support an image sensor, the first PCB segment 10, and the second PCB segment 20. The first PCB segment 10 is arranged between the chassis 40 and the second PCB segment 20.

The clip 50 comprises a first contact portion 51 abutting the first grounding contact surface 12 of the first PCB segment 10. The clip 50 further comprises a second contact portion 52 which extends through the opening 21 of the second PCB segment 20. The second contact portion 52 engages the second grounding contact surface 22 of the second PCB segment 20.

The camera device 1 further comprises a third PCB segment 30. The third PCB segment 30 is provided with the image sensor. The third PCB segment 30 is arranged between the chassis and the first PCB segment 10.

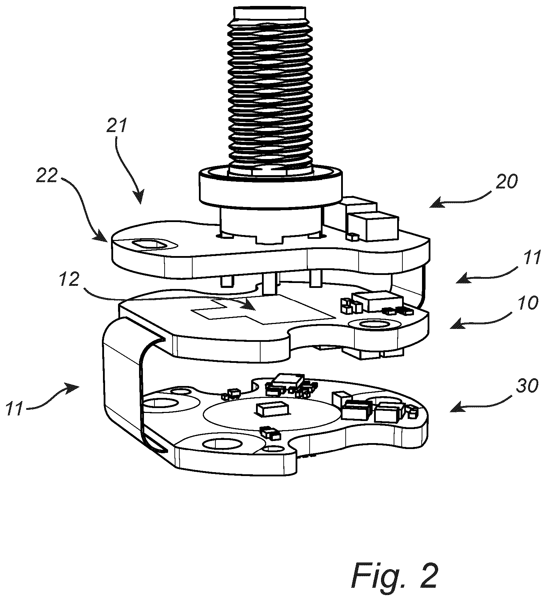

The PCB segments are shown in more detail in Fig. 2. Here the first PCB segment 10 and the second PCB segment 20 are flexibly connected by an FPC film 11. The first PCB segment 10 and the third PCB segment 30 are connected in the same way. Thus, the first PCB segment 10, the second PCB segment 20 and the third PCB segment 30 are portions of a single PCB, connected to each other by the FPC film 11, which is one or more layers in the single PCB. Here, a hard layer is not present between the PCB segments.

Alternatively, to what is shown in Fig. 2, the PCB segments may be three separate PCBs, which are connected to each other by a flex cable.

Referring again to Fig. 1, the camera device 1 further comprises a heat sink member 60. The heat sink member 60 is arranged between the third PCB segment 30 and the first PCB segment 10. The heat sink member 60 dissipates heat from the image sensor provided on the third PCB segment 30.

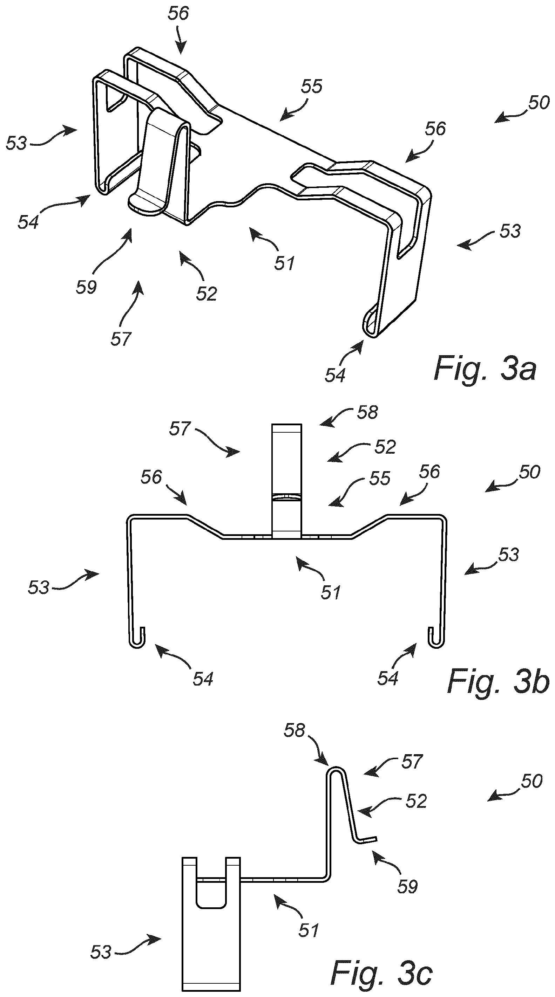

The clip 50 is shown more in detail in Fig. 3a-3c. As can be seen here, the clip 50 comprises two legs 53. When the camera device 1 is assembled, the two legs 53 extend in a direction parallel with the longitudinal axis of the camera device 1. As seen in Fig. 1, the two legs 53 are configured to straddle the first PCB segment 10 in an assembled state of the camera device. Referring to Fig. 3b, each of the two legs 53 is provided with a distal end 54. The distal end 54 is configured for snap fit attachment to the chassis 40. In addition, the clip 50 is configured for sliding engagement with the chassis 40 when snap fitted thereto. That is, the two legs 53 are flexibly resilient such that when the clip 50 is arranged to straddle the first PCB segment 10, the legs 53 will flex outwards and slide along a side surface of the heat sink member 60 and a side surface of the chassis 40 until the two legs 53 reach their end position and snap-fits into the chassis 40.

The clip 50 further comprises a bridging portion 55. The bridging portion 55 extends in a direction perpendicular to the longitudinal axis of the camera device 1 when the camera device 1 is assembled. As can be seen in Fig. 3a-3b, the bridging portion 55 connects the two legs 53.

The bridging portion 55 also comprises the first contact portion 51 of the clip 50. As can be seen in Fig. 1, the first contact portion 51 of the clip 50 abuts the first grounding contact surface 12 of the first PCB segment 10. Thereby, the first PCB segment 10 has a grounding connection via the clip 50 that is connected to the electrically conductive chassis 40.

The bridging portion 55 is not an entirely flat surface. As best illustrated in Fig. 3b, the bridging portion 55 comprises flexible portions 56 such that a spring biased engagement can be established between the clip 50 and the chassis 40. Thereby the first PCB segment 10 is held in place during, and after assembling of the camera device 1. The clamping force of the bridging portion 55 exerted on the first PCB segment 10 ensures that the first PCB segment 10 always has a grounding connection when the camera device 1 is assembled.

Referring to Fig. 3c, the clip 50 comprises a holder portion 57. The holder portion 57 extends in a direction parallel with the longitudinal axis of the camera device 1 when the camera device 1 is assembled. The holder portion 57 extends from the bridging portion 55. Here, the holder portion 57 extends with an offset to the longitudinal axis.

Further, the holder portion 57 has a distal end portion 58. The distal end portion 58 comprises the second contact portion 52. Further, the distal end portion 58 is configured to be inserted into the opening 21 of the second PCB segment 20, as shown in Fig. 1. The opening 21 is complementary shaped to the distal end portion 58 such that when the distal end portion 58 is inserted, a spring biased engagement between the holder portion 57 and the second PCB segment 20 is established. Thereby the second PCB segment 20 is held in place during and after assembly of the camera device 1. In addition, the distal end portion 58 comprises the second contact portion 52. Thereby the spring biased engagement between the holder portion 57 and the second PCB segment 20 ensures that there always is an engagement between the second grounding contact surface 22 and the second contact portion 52 of the clip. In other words, the spring biased engagement ensures the grounding connection of the second PCB segment 20.

The distal end portion 58 is substantially U-shaped. Further, the distal end portion 58 comprises a retaining edge 59. The retaining edge 59 is configured such that the holder portion 57 is restricted from being inserted into the opening 21 of the second PCB segment 20 past the retaining edge 59. Here, the retaining edge 59 is a bent end portion of the holder portion, and is thus unitarily formed with the clip 50. The retaining edge 59 hinders movement of the second PCB segment 20 in a direction transverse to the longitudinal axis of the camera device 1. However, some movement in a direction along the longitudinal axis is still allowed.

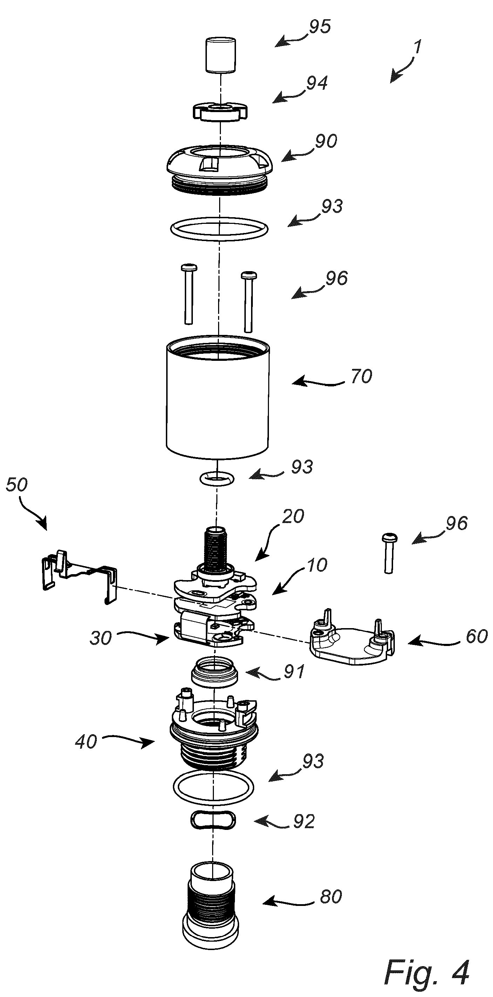

Fig. 4 shows an exploded view of a camera device 1. In Fig. 4 the camera device further comprises a housing 70. The housing 70 encloses the three PCB segments. The housing 70 is connected to the chassis 40 in an assembled state of the camera device 1. However, the housing 70 is not electrically coupled to the chassis 40.

The camera device 1 further comprises a lens unit 80. The lens unit 80 is releasably connected to the chassis 40. Here, the lens unit 80 and the chassis 40 is coupled to each other by a threaded connection. However, it should be understood that several different variations of the connection between the chassis 40 and the lens unit 80 are possible.

The camera device 1 further comprises components such as a chassis back 90, a sensor gasket 91, a wave spring 92, O-rings 93, a nut SMA connector 94, a cover cap 95 and screws 96.

According to a second aspect of the present invention, a camera system is provided. The camera system comprises a processing unit, and at least one camera device 1 in accordance with the first aspect of the invention, as described with reference to Fig. 1-4. The at least one camera device 1 is connected to the processing unit.

Hereinafter, a method for assembling a camera device according to a third aspect of the present invention will be described more in detail. Here, the camera device 1 to be assembled is the same camera device 1 as described in relation to Fig 1-4 above. Some details regarding the camera device 1 will thus be omitted to avoid undue repetition.

Referring to Fig. 4, the camera device 1 comprises a first PCB segment 10. The first PCB segment is provided with a first grounding contact surface 12. The camera device 1 further comprises a second PCB segment 20 provided with an opening 21. The opening 21 is defined by a portion of the second PCB segment 20 forming a second grounding contact surface 22. The camera device 1 further comprises a third PCB segment 30. The third PCB segment 30 is provided with an image sensor. The camera device 1 further comprises a heat sink member 60. The camera device 1 further comprises a chassis 40. The chassis 40 is made of an electrically conductive material. The camera device 1 further comprises a clip 50 made of an electrically conductive material. The clip 50 comprises a first contact portion 51 and a second contact portion 52. The clip 50 is further configured to be snap fitted to the chassis. Here, the camera device 1 further comprises a lens unit 80.

The method of assembling the camera device 1 comprises attaching the lens unit 80 to the chassis 40. Thereafter the third PCB segment 30 is attached to the chassis 40 after active alignment of the image sensor provided on the third PCB segment 30. Thereafter the heat sink member 60 is arranged on the third PCB segment 30. The first PCB segment 10 is then arranged on the heat sink member 60. This is followed by snap fitting the clip 50 to the chassis 40 such that the clip encloses the first PCB segment 10 and the first contact portion 51 of the clip 50 abuts the first grounding contact surface 12 of the first PCB segment 10. Thereafter the second PCB segment 20 is arranged on the clip 50 such that the second contact portion 52 of the clip extends through the opening 21 of the second PCB segment 20 and engages the second grounding contact surface 22 thereof. Thereby, the clip restricts movement of the first PCB segment 10 and the second PCB segment 20 in a direction transverse to the longitudinal axis of the camera device 1.

It will be appreciated that the present invention is not limited to the embodiments shown. Several modifications and variations are thus conceivable within the scope of the invention which thus is exclusively defined by the appended claims.

## Claims

1. A camera device (1) comprising
a first printed circuit board (PCB) segment (10) provided with a first grounding contact surface (12),
a second PCB segment (20) provided with an opening (21) defined by a portion of the second PCB segment (20) forming a second grounding contact surface (22),
a chassis (40) made of an electrically conductive material,
a clip (50) made of an electrically conductive material;
wherein the chassis (40) is configured to support an image sensor and the first (10) and second PCB segment (20),
wherein the first PCB segment (10) is arranged between the chassis (40) and the second PCB segment (20),
wherein the clip (50) comprises a first contact portion (51) abutting the first grounding contact surface (12) of the first PCB segment (10); and a second contact portion (52) extending through the opening (21) of the second PCB segment (20) and engaging the second grounding contact surface (22) thereof, and
**characterized in that** the clip is snap fitted to the chassis (40) and **in that** the clip comprises at least two legs (53) extending in parallel with a longitudinal axis of the camera device (1), wherein the at least two legs (53) straddle the first PCB segment (10), and wherein each of the at least two legs (53) is provided with a distal end (54) configured for snap fit attachment to the chassis (40).

2. The camera device (1) according to claim 1, wherein the clip (50) comprises a bridging portion (55) extending perpendicular to the longitudinal axis and connecting the at least two legs (53), wherein the bridging portion (55) comprises the first contact portion (51).

3. The camera device (1) according to any preceding claim, wherein the clip (50) comprises a holder portion (57) extending in parallel with a longitudinal axis of the camera device (1), the holder portion (57) having a distal end portion (58) configured to be inserted into the opening (21) of the second PCB segment (20) for establishing a spring biased engagement between the holder portion (57) and the second PCB segment (20), wherein the distal end portion (58) comprises the second contact portion (52).

4. The camera device (1) according to claim 3 when dependent upon claim 2, wherein the holder portion (57) extends from the bridging portion (55).

5. The camera device (1) according to claim 4, wherein the holder portion (57) extends with an offset to the longitudinal axis.

6. The camera device (1) according to any one of claims 3-5, wherein the distal end portion (58) is substantially U-shaped.

7. The camera device (1) according to any one of claims 3-6, wherein the distal end portion (58) comprises a retaining edge (59) being configured such that the holder portion (57) is restricted from being inserted into the opening (21) of the second PCB segment (20) past the retaining edge (59).

8. The camera device (1) according to any preceding claim, wherein the clip (50) is configured for sliding engagement with the chassis (40) when snap fitted thereto.

9. The camera device (1) according to any preceding claim, wherein the camera device (1) further comprises a third PCB segment (30) provided with the image sensor, the third PCB segment (30) being arranged between the chassis (40) and the first PCB segment (10).

10. The camera device (1) according to claim 9, wherein the camera device (1) further comprises a heat sink member (60) arranged between the third PCB segment (30) and the first PCB segment (10).

11. The camera device (1) according to any preceding claim, wherein the camera device (1) further comprises a housing (70) enclosing the first (10) and second PCB segment (20).

12. The camera device (1) according to any preceding claim, wherein the camera device (1) further comprises a lens unit (80).

13. A camera system comprising:
a processing unit,
at least one camera device (1) according to any one of claims 1- 12 connected to the processing unit.

14. A method for assembling a camera device (1), the camera device (1) comprising:
a first PCB segment (10) provided with a first grounding contact surface (12),
a second PCB segment (20) provided with an opening (21) defined by a portion of the second PCB segment (20) forming a second grounding contact surface (22),
a third PCB segment (30) provided with an image sensor,
a heat sink member (60),
a chassis (40) made of an electrically conductive material,
a clip (50) made of an electrically conductive material; comprising a first contact portion (51) and a second contact portion (52); and configured to be snap fitted to the chassis (40), the method comprising:
attaching the third PCB segment (30) to the chassis (40),
arranging the heat sink member (60) on the third PCB segment (30),
arranging the first PCB segment (10) on the heat sink member (60),
snap fitting the clip (50) to the chassis (40) such that the clip (50) encloses the first PCB segment (10) and the first contact portion (51) of the clip (50) abuts the first grounding contact surface (12) of the first PCB segment (10),
arranging the second PCB segment (20) on the clip (50) such that the second contact portion (52) of the clip (50) extends through the opening (21) of the second PCB segment (20) and engages the second grounding contact surface (22) thereof,
whereby the clip (50) restricts movement of the first (10) and second PCB segment (20) in a direction transverse to a longitudinal axis of the camera device (1).

## Patentansprüche

1. Kameravorrichtung (1), die Folgendes umfasst:
ein erstes Leiterplatten(PCB)-Segment (10), das mit einer ersten Massekontaktoberfläche (12) versehen ist,
ein zweites PCB-Segment (20), das mit einer Öffnung (21) versehen ist, die durch einen Teil des zweiten PCB-Segments (20) definiert ist, der eine zweite Massekontaktoberfläche (22) bildet,
ein Chassis (40), das aus einem elektrisch leitfähigen Material gefertigt ist,
einen Klammer (50), die aus einem elektrisch leitfähigen Material gefertigt ist;
wobei das Chassis (40) dazu konfiguriert ist, einen Bildsensor und das erste (10) und das zweite PCB-Segment (20) zu unterstützen,
wobei das erste PCB-Segment (10) zwischen dem Chassis (40) und dem zweiten PCB-Segment (20) angeordnet ist,
wobei die Klammer (50) Folgendes umfasst: einen ersten Kontaktteil (51), der an die erste Massekontaktoberfläche (12) des ersten PCB-Segments (10) angrenzt; und einen zweiten Kontaktteil (52), der sich durch die Öffnung (21) des zweiten PCB-Segments (20) erstreckt und mit der zweiten Massekontaktoberfläche (22) davon in Eingriff steht, und
**dadurch gekennzeichnet, dass** die Klammer an dem Chassis (40) durch Schnappverbindung angebracht ist und dass die Klammer wenigstens zwei Schenkel (53) umfasst, die sich parallel zu einer Längsachse der Kameravorrichtung (1) erstrecken, wobei die wenigstens zwei Schenkel (53) das erste PCB-Segment (10) überspannen und wobei jeder der wenigstens zwei Schenkel (53) mit einem distalen Ende (54) versehen ist, das zur Schnappverbindungsbefestigung an dem Chassis (40) konfiguriert ist.

2. Kameravorrichtung (1) nach Anspruch 1, wobei die Klammer (50) einen Brückenteil (55) umfasst, der sich senkrecht zu der Längsachse erstreckt und die wenigstens zwei Schenkel (53) verbindet, wobei der Brückenteil (55) den ersten Kontaktteil (51) umfasst.

3. Kameravorrichtung (1) nach einem vorhergehenden Anspruch, wobei die Klammer (50) einen Halterungsteil (57) umfasst, der sich parallel zu einer Längsachse der Kameravorrichtung (1) erstreckt, wobei der Halterungsteil (57) einen distalen Endteil (58) aufweist, der dazu konfiguriert ist, in die Öffnung (21) des zweiten PCB-Segments (20) eingeführt zu werden, um einen federvorgespannten Eingriff zwischen dem Halterungsteil (57) und dem zweiten PCB-Segment (20) herzustellen, wobei der distale Endteil (58) den zweiten Kontaktteil (52) umfasst.

4. Kameravorrichtung (1) nach Anspruch 3, wenn abhängig von Anspruch 2, wobei sich der Halterungsteil (57) von dem Brückenteil (55) erstreckt.

5. Kameravorrichtung (1) nach Anspruch 4, wobei sich der Halterungsteil (57) mit einem Versatz zu der Längsachse erstreckt.

6. Kameravorrichtung (1) nach einem der Ansprüche 3-5, wobei der distale Endteil (58) im Wesentlichen U-förmig ist.

7. Kameravorrichtung (1) nach einem der Ansprüche 3-6, wobei der distale Endteil (58) eine Anschlagskante (59) umfasst, die so konfiguriert ist, dass der Halterungsteil (57) daran gehindert wird, in die Öffnung (21) des zweiten PCB-Segments (20) über die Anschlagskante (59) hinaus eingeführt zu werden.

8. Kameravorrichtung (1) nach einem vorhergehenden Anspruch, wobei die Klammer (50) für einen gleitenden Eingriff mit dem Chassis (40) konfiguriert ist, wenn sie durch Schnappverbindung daran angebracht wird.

9. Kameravorrichtung (1) nach einem vorhergehenden Anspruch, wobei die Kameravorrichtung (1) ferner ein drittes PCB-Segment (30) umfasst, das mit dem Bildsensor versehen ist, wobei das dritte PCB-Segment (30) zwischen dem Chassis (40) und dem ersten PCB-Segment (10) angeordnet ist.

10. Kameravorrichtung (1) nach Anspruch 9, wobei die Kameravorrichtung (1) ferner ein Kühlkörperelement (60) umfasst, das zwischen dem dritten PCB-Segment (30) und dem ersten PCB-Segment (10) angeordnet ist.

11. Kameravorrichtung (1) nach einem vorhergehenden Anspruch, wobei die Kameravorrichtung (1) ferner ein Gehäuse (70) umfasst, das das erste (10) und das zweite PCB-Segment (20) umschließt.

12. Kameravorrichtung (1) nach einem vorhergehenden Anspruch, wobei die Kameravorrichtung (1) ferner eine Linseneinheit (80) umfasst.

13. Kamerasystem, das Folgendes umfasst:
eine Verarbeitungseinheit,
wenigstens eine Kameravorrichtung (1) nach einem der Ansprüche 1-12, die mit der Verarbeitungseinheit verbunden ist.

14. Verfahren zum Montieren einer Kameravorrichtung (1), wobei die Kameravorrichtung (1) Folgendes umfasst:
ein erstes PCB-Segment (10), das mit einer ersten Massekontaktoberfläche (12) versehen ist,
ein zweites PCB-Segment (20), das mit einer Öffnung (21) versehen ist, die durch einen Teil des zweiten PCB-Segments (20) definiert ist, der eine zweite Massekontaktoberfläche (22) bildet,
ein drittes PCB-Segment (30), das mit einem Bildsensor versehen ist,
ein Kühlkörperelement (60),
ein Chassis (40), das aus einem elektrisch leitfähigen Material gefertigt ist,
eine Klammer (50), die aus einem elektrisch leitfähigen Material gefertigt ist; die einen ersten Kontaktteil (51) und einen zweiten Kontaktteil (52) umfasst; und die dazu konfiguriert, an dem Chassis (40) durch Schnappverbindung angebracht zu werden, wobei das Verfahren Folgendes umfasst:
Befestigen des dritten PCB-Segments (30) an dem Chassis (40),
Anordnen des Kühlkörperelements (60) auf dem dritten PCB-Segment (30),
Anordnen des ersten PCB-Segments (10) auf dem Kühlkörperelement (60),
Anbringen der Klammer (50) an dem Chassis (40) durch Schnappverbindung, so dass die Klammer (50) das erste PCB-Segment (10) umschließt und der erste Kontaktteil (51) der Klammer (50) an die erste Massekontaktoberfläche (12) des ersten PCB-Segments (10) anliegt,
Anordnen des zweiten PCB-Segments (20) auf der Klammer (50), so dass sich der zweite Kontaktteil (52) der Klammer (50) durch die Öffnung (21) des zweiten PCB-Segments (20) erstreckt und mit der zweiten Massekontaktoberfläche (22) davon in Eingriff steht,
wodurch die Klammer (50) eine Bewegung des ersten (10) und des zweiten PCB-Segments (20) in einer Richtung quer zu einer Längsachse der Kameravorrichtung (1) einschränkt.

## Revendications

1. Dispositif de caméra (1), comprenant
un premier segment de carte de circuit imprimé (Printed Circuit Board, PCB) (10) pourvu d'une première surface de contact de mise à la terre (12),
un deuxième segment de PCB (20) pourvu d'une ouverture (21) définie par une partie du deuxième segment de PCB (20) formant une seconde surface de contact de mise à la terre (22),
un châssis (40) fait d'un matériau électroconducteur,
une agrafe (50) faite d'un matériau électroconducteur ;
dans lequel le châssis (40) est configuré pour supporter un capteur d'image et les premier (10) et second (20) segments de PCB,
dans lequel le premier segment de PCB (10) est agencé entre le châssis (40) et le deuxième segment de PCB (20), dans lequel l'agrafe (50) comprend une première partie de contact (51) venant en butée contre la première surface de contact de mise à la terre (12) du premier segment de PCB (10) ; et une seconde partie de contact (52) s'étendant à travers l'ouverture (21) du deuxième segment de PCB (20) et entrant en prise avec la seconde surface de contact de mise à la terre (22) de celui-ci, et
**caractérisé en ce que** l'agrafe est ajustée avec encliquetage sur le châssis (40) et **en ce que** l'agrafe comprend au moins deux pattes (53) s'étendant en parallèle à un axe longitudinal du dispositif de caméra (1), dans lequel les au moins deux pattes (53) chevauchent le premier segment de PCB (10), et dans lequel chacune des au moins deux pattes (53) est pourvue d'une extrémité distale (54) configurée pour la fixation par ajustement avec encliquetage au châssis (40).

2. Dispositif de caméra (1) selon la revendication 1, dans lequel l'agrafe (50) comprend une partie faisant pont (55) s'étendant perpendiculairement à l'axe longitudinal et raccordant les au moins deux pattes (53), dans lequel la partie faisant pont (55) comprend la première partie de contact (51).

3. Dispositif de caméra (1) selon une quelconque revendication précédente, dans lequel l'agrafe (50) comprend une partie à organe de retenue (57) s'étendant en parallèlement à un axe longitudinal du dispositif de caméra (1), la partie à organe de retenue (57) ayant une partie d'extrémité distale (58) configurée pour être insérée dans l'ouverture (21) du deuxième segment de PCB (20) pour établir une entrée en prise sollicitée par ressort entre la partie à organe de retenue (57) et le deuxième segment de PCB (20), dans lequel la partie d'extrémité distale (58) comprend la seconde partie de contact (52).

4. Dispositif de caméra (1) selon la revendication 3 lorsqu'elle dépend de la revendication 2, dans lequel la partie à organe de retenue (57) s'étend depuis la partie faisant pont (55).

5. Dispositif de caméra (1) selon la revendication 4, dans lequel la partie à organe de retenue (57) s'étend avec un décalage par rapport à l'axe longitudinal.

6. Dispositif de caméra (1) selon l'une quelconque des revendications précédentes 3 à 5, dans lequel la partie d'extrémité distale (58) est sensiblement en forme de U.

7. Dispositif de caméra (1) selon l'une quelconque des revendications précédentes 3 à 6, dans lequel la partie d'extrémité distale (58) comprend un bord de retenue (59) configuré de manière telle que la partie à organe de retenue (57) est empêchée d'être insérée dans l'ouverture (21) du deuxième segment de PCB (20) au-delà du bord de retenue (59).

8. Dispositif de caméra (1) selon une quelconque revendication précédente, dans lequel l'agrafe (50) est configurée pour l'entrée en prise coulissante avec le châssis (40) lorsqu'elle est ajustée avec encliquetage que celui-ci.

9. Dispositif de caméra (1) selon une quelconque revendication précédente, dans lequel le dispositif de caméra (1) comprend en outre un troisième segment de PCB (30) pourvu du capteur d'image, le troisième segment de PCB (30) étant agencé entre le châssis (40) et le premier segment de PCB (10).

10. Dispositif de caméra (1) selon la revendication 9, dans lequel le dispositif de caméra (1) comprend en outre un élément dissipateur de chaleur (60) agencé entre le troisième segment de PCB (30) et le premier segment de PCB (10).

11. Dispositif de caméra (1) selon une quelconque revendication précédente, dans lequel le dispositif de caméra (1) comprend en outre un boîtier (70) entourant les premier (10) et deuxième (20) segments de PCB.

12. Dispositif de caméra (1) selon une quelconque revendication précédente, dans lequel le dispositif de caméra (1) comprend en outre une unité de lentille (80).

13. Système de caméra, comprenant :
une unité de traitement,
au moins un dispositif de caméra (1) selon l'une quelconque des revendications précédentes 1 à 12 raccordée à l'unité de traitement.

14. Procédé pour assembler un dispositif de caméra (1), le dispositif de caméra (1) comprenant :
un premier segment de PCB (10) pourvu d'une première surface de contact de mise à la terre (12),
un deuxième segment de PCB (20) pourvu d'une ouverture (21) définie par une partie du deuxième segment de PCB (20) formant une seconde surface de contact de mise à la terre (22),
un troisième segment de PCB (30) pourvu d'un capteur d'image,
un élément dissipateur de chaleur (60),
un châssis (40) fait d'un matériau électroconducteur,
une agrafe (50) faite d'un matériau électroconducteur ;
comprenant une première partie de contact (51) et une seconde partie de contact (52) ; et configurée pour être ajustée avec encliquetage sur le châssis (40), le procédé comprenant :
la fixation du troisième segment de PCB (30) au châssis (40),
l'agencement de l'élément dissipateur de chaleur (60) sur le troisième segment de PCB (30),
l'agencement du premier segment de PCB (10) sur l'élément dissipateur de chaleur (60),
l'ajustement avec encliquetage de l'agrafe (50) sur le châssis (40) de manière telle que l'agrafe (50) entoure le premier segment de PCB (10) et la première partie de contact (51) de l'agrafe (50) vient en butée contre la première surface de contact de mise à la terre (12) du premier segment de PCB (10),
l'agencement du deuxième segment de PCB (20) sur l'agrafe (50) de manière telle que la seconde partie de contact (52) de l'agrafe (50) s'étend à travers l'ouverture (21) du deuxième segment de PCB (20) et entre en prise avec la seconde surface de contact de mise à la terre (22) de celui-ci,
moyennant quoi l'agrafe (50) limite le mouvement des premier (10) et deuxième (20) segments de PCB dans une direction transversale à un axe longitudinal du dispositif de caméra (1).
